(19) Europäisches Patentamt
European Patent Office
Office européen des brevets

(11) Publication number: 0 404 522 A2

# (12) EUROPEAN PATENT APPLICATION

(21) Application number: 90306686.8

(51) Int. Cl.5: G03F 3/10

(22) Date of filing: 19.06.90

(30) Priority: 20.06.89 US 368688

(43) Date of publication of application:
27.12.90 Bulletin 90/52

(84) Designated Contracting States:
BE CH DE FR GB IT LI LU NL

(71) Applicant: HOECHST CELANESE CORPORATION
Route 202-206 North
Somerville, New Jersey(US)

(72) Inventor: Koletar, Gabor I.
212 Dogwood Lane
Berkeley Heights, New Jersey(US)

(74) Representative: De Minvielle-Devaux, Ian Benedict Peter et al
CARPMAELS & RANSFORD 43, Bloomsbury Square
London WC1A 2RA(GB)

## (54) Multilayer imaging article for transfer color proofing.

(57) This invention relates to negative or positive working transfer type photosensitive sheet constructions which, upon exposure to an actinic radiation source through a screened image, can accurately reproduce said image. The construction is useful as a color proofing film which can be employed to predict the image quality from a lithographic printing process.

EP 0 404 522 A2

## BACKGROUND OF THE INVENTION

In the graphic arts, it is desirable to produce a color proof to assist a printer correcting a set of photomasks which will be used in exposing printing plates. The proof should reproduce the color quality that will be obtained during the printing process, and it must be a consistent duplicate of the desired halftone or line image, and should neither gain nor lose color. Visual examination of a color proof should reveal any defects on the photomask; the best color rendition to be expected from press printing of the material; the correct gradation of all colors and whether grays are neutral; the need, if any for subduing any of the colors and/or giving directions for altering the film photomask before making the printing plates.

Color proofing sheets for multi-colored printing have heretofore been made by using a printing press proof which requires taking all the steps necessary for actual multicolor printing. Such a conventional method of color proofing has been costly and time consuming. Alternate color proofing methods have therefore been developed to simulate the quality of press proofs. There are two known types of photographic color proofing methods, namely, the surprint type and the overlay type.

In the overlay type of color proofing, an independent transparent plastic support is used for producing an image of each color separation film. A number of such supports carrying colored images are then superimposed upon each other and placed on a white sheet to produce a color proof. The overlay type of color proofing method has the disadvantage that the superimposed plastic supports tend to darken the color sheet, and, as a result, the impression of the color proofing sheet thus prepared becomes different from copies actually obtained by a conventional printing press proof. Its primary advantage is that it is quick and can serve as a progressive proof by combining any two or more colors in register.

In the surprint type of color proofing, a color proofing sheet is prepared by successively producing images of different colors from different color separation films onto a single receptor sheet. This is done by utilizing a single opaque support and by applying toners, photosensitive solutions or coatings of photosensitive materials of corresponding colors on the opaque support in succession. An example of this approach is described in U.S. Patent No. 3,671,236. An advantage of the surprint type of color proof is that the color saturation is not influenced by superimposed plastic supports. This method more closely resembles the actual printing and eliminates the color distortion inherent in the overlay system.

Various processes for producing copies of an image embodying photopolymerization and thermal transfer techniques are known as shown in U.S. Patent Nos. 3,060,023; 3,060,024; 3,060,025; 3,481,736; and 3,607,264. In these processes, a photopolymerizable layer coated on a suitable support is imagewise exposed to a photographic transparency. The surface of the exposed layer is then pressed into contact with the image receptive surface of a separate element and at least one of the elements is heated to a temperature above the transfer temperature of the unexposed portions of the layer. The two elements are then separated, whereby the thermally transferable, unexposed, image areas of the composite transfer to the image receptive element. If the element is not precolored, the tacky unexposed image may now be selectively colored with a desired toner. The colored matter preferentially adheres to the clear unpolymerized material. U.S. Patent No. 3,574,049 provides a transfer process for printing a design on a final support which comprises (a) printing a design onto a temporary support, (b) superimposing the temporary support and the final support, (c) applying heat and/or pressure to the superimposed structure formed in (b), and (d) separating the temporary support from the final support which retains the printed design. The affinity of the design for the temporary support is lower than its affinity for the final support.

In U.S. Patent No. 3, 721,557 a method of transferring colored images is claimed which provides a stripping layer coated between the photosensitive element and the support. When the photosensitive layer is exposed to actinic light and developed, the more soluble portions are selectively removed to produce a visible image. The image-carrying support is pressed against a suitable adhesive coated receptor member and, subsequently, the carrier support sheet is stripped to accomplish the transfer of the image. A fresh layer of adhesive is applied to the receptor for each subsequent transfer.

U.S. Patents 4,650,738 and 4,659,642 describe improved color proofing films wherein colored photosensitive images are applied to a receiver sheet. Each color separated image appears directly connected to the next color separated image without interfering intermediate films. This invention provides a further improvement by eliminating or reducing exposure interference between the colorants and photosensitizers used in the system. The invention shows improved photosensitivity especially for black and yellow colored elements.

## SUMMARY OF THE INVENTION

The invention provides a multilayered imaging element which comprises

i. a transparent support having a release surface; and

ii. a photosensitive layer directly on said release surface, which photosensitive layer is substantially free of dyes and pigments and comprises in admixture a light sensitive component selected from the group consisting of polymeric diazonium compounds and quinone diazides and optionally at least one aqueous alkaline soluble or swellable binding resin, wherein said binding resin is present in sufficient amount to bind the photosensitive layer components into a uniform film, and wherein said light sensitive component is present in sufficient amount to cause an imagewise differentiation in said photosensitive layer upon imagewise exposure to sufficient imaging energy; and

iii. a colored layer directly on said photosensitive layer, which colored layer is substantially free of photosensitive compounds, which colored layer comprises an aqueous alkaline soluble or swellable binder resin in sufficient amount to bind the colored layer components into a uniform film, and at least one colorant in sufficient amount to uniformly color said colored layer; and

iv. a thermally activated adhesive directly on said colored layer.

The invention also provides a method for forming a colored image which comprises

A. providing the aforementioned element and then

B. either

i. laminating said element with heat and pressure via said adhesive layer to a developer resistant receiver sheet; and removing said support by the application of peeling forces; and imagewise exposing said photosensitive layer to actinic radiation; or

ii. laminating said element with heat and pressure via said adhesive layer to a developer resistant receiver sheet; and imagewise exposing said photosensitive layer to actinic radiation; and removing said support by the application of peeling forces; and

C. removing the non-image areas of said photosensitive layer with a liquid developer, which removing is conducted at a temperature at which said adhesive layer is substantially non-tacky; and preferably

D. repeating steps A through C at least once whereby another photosensitive element having at least one different colorant is laminated onto said receiver sheet over the non- removed portions of the previously laminated photosensitive layer of layers.

In another embodiment of the invention, the photosensitive layer is substantially free of binding resins and the light sensitive component is selected such that it is itself a film forming material and is present in a sufficient amount to form a uniform film on the transparent support. Systems prepared according to this embodiment demonstrate even greater increased photosensitivity.

## DETAILED DESCRIPTION OF THE PREFERRED EMBODIMENT

In carrying out the invention, one provides a photographic element which broadly comprises a transparent support having a release surface, a photosensitive layer on the release surface, a colored,layer on the photosensitive layer and an adhesive layer on the colored layer. Optional additional layers containing anti-halation materials, adhesion promoters or release agents may also be used.

In the preferred embodiment, the transparent support is composed of a dimensionally and chemically stable base material which does not significantly change its size, shape or chemical properties as the result of the heating coating or other treatments which it must undergo. One preferred material is polyethylene terephthalate. In the usual case it has a thickness of from about 1 to about 10 mils, a more preferred thickness is from about 2-5 mils and most preferably from about 2-3 mils. Suitable films include Hostaphan 3000, available from Hoechst Celanese Corporation, Mylar D, available from DuPont and Melinex grades 0, 052,442; 516 and S, available from ICI. The surface of the substrate may be smooth or may be provided with a matte texture by various methods known in the art.

Matte films include Melinex 377 and 470 from ICI. These materials have the unique property of giving the final image a desired matte finish without any extra steps. One can control the gloss of the final image by properly selecting the matte finish of the temporary support. This effect works because the top layer of the final image is originally in contact with this matte surface. This does not occur with a separate release layer between the temporary support and photosensitive layer. An additional advantage of coating on a matte surface is that subsequent transferred layers generally adhere better to a rough surface than to a

smooth surface.

A similar matte finish of the final image can be obtained by embossing the shiny, top surface of the image with a matte material, such as described above. This is done by laminating together the final image and matte material under pressure and temperature. The matte material is then generally removed after lamination. The advantage of this method is that the finish of the final proof can be varied. Furthermore, the matting material can be used repeatedly.

A third method for producing a matte finish uses a heat transferable layer, such as Butvar 90, available from Monsanto, coated onto a film with a rough surface, such as Melinex 329, available from ICI. The adhesive layer is laminated to the final image under pressure and temperature. Then the film with the rough surface is peeled off. The rough surface imparts a matte finish to the final image. The advantage is that all layers appear matte and that the extra adhesive layer protects the image. U.S. patents 4,294,909 and 4,376,159, also suggests various methods for making a matte surface.

In either case, the support must have a release surface, that is, it must be capable of releasably holding the photosensitive layer thereto. This may be accomplished either by the substrate surface being inherently releasable, being rendered releasable by a suitable treatment or being provided with a release layer over the substrate surface. Such a release layer may comprise polyvinyl alcohol.

Releasably bonded to the release surface is the photosensitive layer. The photosensitive layer broadly comprises a photosensitizer, and may contain a binding resin and other optional ingredients such as plasticizers, acid stabilizers, surfactants, antistatic compositions, uv absorbers and residual coating solvents.

The photosensitizer is preferably a light sensitive, polymeric diazonium salt or a quinone diazide. The most preferred diazonium salt photosensitizer is the polycondensation product of 3-methoxy-4-diazo-diphenyl amine sulfate and 4,4′-bis-methoxy methyl-diphenly ether, precipitated as mesitylene sulfonate as taught in U.S. 3,849,392. Other suitable photosensitizers are taught in U.S. 4,436,804. The diazo compounds of choice are preferably soluble in organic solvents.

The most preferred quinone diazide photosensitizer is the ester of bis-(3-benzoyl-4,5,6 trihydroxy phenyl)-methane and 2-diazo-1-naphthol-5-sulfonic acid as taught in U.S. 4,407,426. Other suitable photosensitizers are taught in U.S. 4,266,001, 3,106,365, 3,148,983 and 3,281,239.

Suitable binding resins for both the photosensitive and colored layers include polyvinyl butyral, styrene maleic anhydride copolymer, and a binder resin having the general formula

-A-B-C-

wherein a plurality of each of components A, B and C occur in ordered or random sequence in the resin and wherein A is present in said resin at about 5% to about 30% by weight and comprises groups of the formula

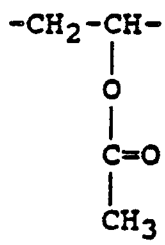

B is present in said resin about 4% to about 30% by weight and comprises groups of the formula

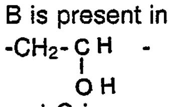

and C is present in said resin at about 50% to about 91% by weight; the weight amount of components A, B, and C being based on the total weight of the resin, and comprises acetal groups consisting of groups of the formulae

I) 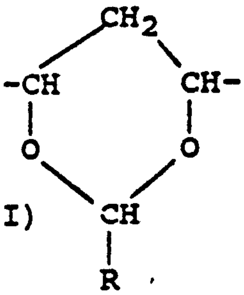 , II) 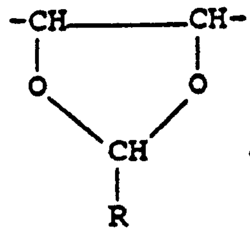 and III) 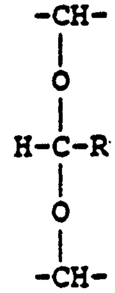

where R is lower alkyl or hydrogen, and wherein said group I is present in component C from about 75% to about 85%, group II is present in component C from about 3% to about 5%, and group III is present in component C from about 10% to about 22%, the percent basis for the acetal groups I, II, and III being on a mol basis of acetal groups I, II, and III of component C.

The above exemplified resin is more fully described in U.S. Patent 4,670,507 which is incorporated herein by reference. Polyvinyl butyral resins include Butvar B72, B76 and B90 and styrene-maleic anhydride resins include Scripset 540 and 550, respectively and are all available from Monsanto. An important resin selection criterion is that it must be a good film former.

In an alternative embodiment of the invention, the resin is omitted from the photosensitive layer and the light sensitive component is itself a good film former.

The colorants useful for the colored layer of the present invention include various classes of dyes and pigments. In the most preferred embodiment, pigments having an average particle size of about 1 micrometer of less are used.

Preferred colorants for this invention are pigments rather than dyes. They are dispersed in a small amount of polymethyl methacrylate/methacrylic acid (85/15) vehicle or the above terpolymer and methyl ethyl ketone solvent. One preferred vehicle is a 50:50 mixture of propylene glycol methyl ether and gamma butyrolactone. The pigment particles are ground to a small enough particle size to duplicate the particle size and color of equivalent inks.

In the preferred embodiment, the photosensitive and colored layers have a coating weight between approximately 0.1 and $5.0 g/m^2$. The most preferred weight is from about 0.5 to $2.0 g/m^2$.

In the preferred embodiment, when a binding resin is used, the diazonium salt or quinone diazide is present in the photosensitive layer in an amount of from about 5 to about 40 percent by weight; or more preferably from about 10 to about percent by weight. When a binding resin is not used, the photosensitive layer is composed of essentially all light sensitive components except for minor amounts of the aforementioned optional ingredients.

In the preferred embodiment, the colorant is present in the colored layer in an amount of from about 10 to about 40 percent by weight; or more preferably from about 13 to 34 percent by weight. The colorant is in admixture with a binding resin which is preferably one of the same binding resins as listed for the photosensitive layer.

In the preferred embodiment, the binding resin is present in the colored layer, and the photosensitive layer, when a binder is used, layer in an amount of from about 25 to about 80 parts by weight; or more preferably from about 32 to about 75 parts by weight.

The adhesive layer comprises a thermally activated adhesive which is preferably polyvinyl acetate or vinyl acetate containing copolymers, and may contain such other desired components as uv absorbers, anti-static compositions and plasticizers. Useful polyvinyl acetates non-exclusively include Mowilith DM-6, 20, DM-22, 25, 30 and mixtures thereof, available from Hoechst AG. These are usually dispersed in water, or dissolved in methyl isobutyl ketone or n-butyl acetate or other solvent compositions for coating on the photosensitive layer. It is then dried to a coating weight of from about 5 to about $30 g/m^2$, more preferably from about 10 to about $20 g/m^2$. The layer may optionally contain a uv absorber such as Uvinul d-50 from G.A.F. It may also contain a plasticizer such as Resoflex R-296, available from Cambridge Industries. It may also contain antistats, such as Gafac and Gafstat from G.A.F. It may also contain other resins, such as Nitrocellulose RS 1/2, available from Hercules. The adhesive layer should not be tacky to the touch, during storage or during development of the photosensitive element. The layer should have a softening point in the range of from about 60°C to about 180°C, preferably 60°C to 120°C, more preferably 60°C to 100°C. In the preferred embodiment, the polyvinyl acetate is present in the adhesive layer in an amount of greater

than about 50 percent by weight. The plasticizer may be present in an amount of up to about 30 percent by weight, the uv absorber up to about 20 percent by weight, and other resins up to about 50 percent by weight.

In operation, the photosensitive element is laminated to a receptor sheet via the adhesive layer. The receiver sheet should be resistant to any adverse effects which may be caused by the developer of choice. For example, the receiver sheet should be water resistant if aqueous developers are used. Plastic or plastic coated receiver sheets are useful for this purpose.

Useful receiver sheets include Melinex 329; 339; 994 and 3020 from ICI. Other white and non-white receiver sheets may also be used. Rough textured and/or adhesion promoted surfaces are preferred for the receiver, which must be able to withstand the laminating and development processes.

Lamination may be conducted by putting the receiver sheet in contact with the adhesive side of the colored composite and then introducing the two materials into the nip of a pair of heated laminating rollers under suitable pressure. Suitable laminating temperatures usually range from about 60 °C to about 90 °C, preferably about 75 °C to abut 85 °C. After lamination, the support is peeled away, usually merely employing manual peeling forces. The adhesive and photosensitive layers thus remain on the receiver sheet.

The photosensitive layer is imagewise exposed by means well known in the art after lamination. Such exposure may be conducted by exposure to a uv light source through a photomask under vacuum frame conditions. Exposure may be performed with actinic light through a conventional negative flat. Exposures after lamination and peel apart are preferred for emulsion-to-emulsion contact. Mercury vapor discharge lamps are preferred over metal halide lamps. Filters may be used to reduce light scattering in the material.

After lamination, peel apart and exposure, the photosensitive layer is developed by dissolving the non-exposed area in a suitable developer and dried. The adhesive layer is not removed by this development. Suitable developers non-exclusively include:

| | | |
|---|---|---|
| I. | | |
| | water | 95.0 |
| | sodium decyl sulphate | 3.0 |
| | disodium phosphate | 1.5 |
| | sodium metasilicate | 0.5 |
| II. | | |
| | water | 89.264 |
| | monosodium phosphate | 0.269 |
| | trisodium phosphate | 2.230 |
| | sodium tetradecyl sulfate | 8.237 |

Any developer solution which satisfactorily removes the non-exposed areas of the photosensitive layer after exposure while retaining the image areas may be used. The selection of developer is well within the ability of the skilled artisan.

The process can then be repeated whereby another photosensitive element having a different color is laminated to the same receiver sheet over the previously formed image. In the usual case, four colored layers are employed to produce a full color reproduction of a desired image. These are cyan, magenta, yellow and black.

The following non-limiting examples serve to illustrate the invention.

Example 1: (Comparative)

The following formulations (in grams), at the listed reflection densities are coated on Melinex-516 polyester film available commercially from ICI:

| | Black | Cyan | Yellow | Magenta |
|---|---|---|---|---|
| Methyl Cellosolve | 37.00 | - | - | 30.00 |
| Dowanol PM | - | 34.00 | 34.00 | - |
| Methyl Ethyl Ketone | 25.00 | 34.00 | 34.00 | 40.00 |
| Diacetone Alcohol | 13.00 | 13.00 | 17.00 | 15.00 |
| Scripset-540* | 3.37 | 2.61 | 2.51 | 1.75 |
| Fuly Hydrolized S-540* | 0.37 | - | - | - |
| BYK-301 (flow additive) | 0.02 | 0.02 | 0.02 | 0.02 |
| Film Forming Diazo** | 1.08 | 1.07 | 1.05 | 1.10 |
| Carbon Black Dispersion | 20.00 | - | - | - |
| Phthalo Blue Dispersion | - | 13.00 | - | - |
| Diarylidine Yellow Dispersion | - | - | 13.00 | - |
| Lithol Red Dispersion | - | - | - | 12.00 |
| Reflection Density of coating | 1.36 | 1.39 | 0.88 | 1.28 |

The color dispersions are prepared by milling together a mixture of 5% of the dry pigment powder, 5% of polyvinyl propional resin disclosed in U.S. 4,822,720 in 90% of 1:1 mixture of Dowanol PM and gamma butyrolactone.

The dried color films are next overcoated with an adhesive solution, which is Mowilith 30 brand polyvinyl acetate from Hoechst AG, at a dry coating weight of 12-15 grams per square meter, and dried.

Each of the foils is laminated to Melinex 3020 polyester film, and the clear Melinex 516 is removed.

The films are exposed using a 1000 watt metal halide lamp, and processed in NAPS/PAPS developer commercially available from Hoechst Celanese Corporation. The required exposure times to obtain a clear step 6 on a 21 step sensitivity for each color foil are as follows:

| | |
|---|---|
| Black: | 112 secs. |
| Cyan: | 112 secs. |
| Yellow: | 224 secs. |
| Magenta: | 56 secs. |

* Styrene-Maleic anhydride resin available from Monsanto

** condensation product of 4,4′-bis(methoxymethyl)diphenyl ether with 3-methoxy-4-diazonium diphenyl amine bisulfate precipitated as the chloride salt, redissolved in water and reprecipitated as the mesitylene sulfonate.

Example 2:

Four sheets of Melinex 516 polyester film are coated with a solution of the diazo from Example 1 in Methyl Cellosolve and dried to give a dry coating weight of 0.2-0.5 grams per square meter. Sheets of these foils are next overcoated with each of the above color formulations, from which the sensitizer has been eliminated, at the same reflection densities as in Example 1. Each color film is next overcoated with the adhesive, laminated, exposed and processed as in Example 1. The following exposure times are required to obtain a clear step 6 on the 21 step exposure guide.

| | |
|---|---|
| Black: | 14 secs. |
| Cyan: | 7 secs. |
| Yellow: | 10 secs. |
| Magenta: | 28 secs. |

Example 3:

The following color solutions are prepared (in grams)

| | Black | Cyan | Yellow | Magenta |
|---|---|---|---|---|
| Methyl Ethyl Ketone | 72.00 | 84.00 | 85.00 | 85.00 |
| Scripset-540 | 3.22 | 2.61 | 2.51 | 1.75 |
| Carbon Black Dispersion | 25.23 | - | - | - |
| Phthalo Blue Dispersion | - | 13.00 | - | - |
| Diarylidine Yellow Dispersion | - | - | 13.00 | - |
| Lithol Red Dispersion | - | - | - | 12.00 |

These coatings are applied to polyester sheets previously coated with the diazo from Example 1, overcoated with polyvinyl acetate adhesive and processed according to Example 1.

Exposure studies show that reductions in exposure times, similar to those found in Example 2 are obtained.

Example 4:

Polyester films are coated with the following photosensitive layer:

| | |
|---|---|
| Dowanol PM | 31.67 |
| Methyl Ethyl Ketone | 40.83 |
| Diacetone Alcohol | 22.50 |
| reaction product of polyvinyl butyral and maleic anhydride from U.S. Patent 4,631,243 | 0.83 |
| Diazo from Example 1 | 4.17 |

The final dry coating weight is 0.5 grams per square meter.

Sheets of these sensitized polyester are overcoated with the color solutions from Example 2, adhesive overcoated and laminated to Melinex-3020 polyester.

A Berkey Ascor exposure frame, equipped with a 2000 watt metal halide lamp and a light integrator is used to expose these films along with films prepared according to Example 1. Using 5 integrator units of exposure and processing, the following clear steps on the 21 step exposure guide are obtained:

| | Black | Cyan | Yellow | Magenta |
|---|---|---|---|---|
| Films from Example 1: | no image | clear 4 | clear 4 | clear 7 |
| Films from Example 4: | clear 6 | clear 7 | clear 8 | clear 10 |

Example 5: (comparative)

The following formulation (in parts by weight) is coated on Melinex-516 polyester film from ICI:

| | |
|---|---|
| Dowanol PM | 37.00 |
| Methyl ethyl ketone | 27.00 |
| Diacetone Alcohol | 11.00 |
| gamma butyrolactone | 8.00 |
| Butvar B-90 (polyvinyl butyral from Monsanto) | 0.42 |
| Scripset-540 | 1.85 |
| Diazide* | 2.26 |
| BYK-301 | 0.01 |
| Black Dispersion | 11.40 |

* ester of bis-(3-benzoyl-4,5,6 trihydroxyphenyl)-methane and 2-diazo-1-naphthol-5-sulfonic acid as taught in U.S. Patent 4,407,926.

The optical density of the coating is 1.48.

The dried coating is overcoated with a solution of Mowilith-polyvinyl acetate dissolved in i-Butyl Acetate, at a dry coating weight of 12 grams per square meter.

The film so prepared is laminated to Melinex-3020, and the Melinex-516 film is removed, exposing the photosensitive coating.

The film is exposed using the conditions of Example 4. An exposure of 60 Integrator units is required to obtain a clear step 3 on the 21 step sensitivity guide.

Example 6:

The following photosensitive solution is coated on Melinex-516:

| | |
|---|---|
| Dowanol PM | 20.71g |
| Methyl ethyl ketone | 15.31g |
| Diacetone Alcohol | 6.39g |
| Butvar B-90 | 1.06g |
| Scripset-540 | 1.03g |
| Diazide from Example 5 | 0.94g |

The dried coating weight is 0.5g per square meter.

The coating prepared above is next overcoated with the following black color solution:

| | |
|---|---|
| Ethanol | 72.00g |
| Scripset-540 | 3.22g |
| BYK-301 | 0.01g |
| Black Dispersion | 25.23g |

The black density obtained is 1.4-1.5.

The films are next overcoated with a solution of Mowilith-30, and exposed and processed as in Example 5. It is found that an exposure of 10 integrator units is necessary to obtain a clear step 3 on the 21 step sensitivity guide, showing a 6 fold increase in sensitivity over the sample prepared in Example 5.

**Claims**

1. A multilayered imaging element which comprises

i. a transparent support having a release surface; and

ii. a photosensitive layer directly on said release surface, which photosensitive layer is substantially

free of dyes and pigments and comprises in admixture a light sensitive component selected from the group consisting of polymeric diazonium compounds and quinone diazides, and at least one aqueous alkaline soluble or swellable binding resin, wherein said binding resin is present in sufficient amount to bind the photosensitive layer components into a uniform film, and wherein said light sensitive component is present in sufficient amount to cause an imagewise differentiation in said photosensitive layer upon imagewise exposure to sufficient imaging energy; and

iii. a colored layer directly on said photosensitive layer, which colored layer is substantially free of diazonium compounds and quinone diazides, which colored layer comprises an aqueous alkaline soluble or swellable binder resin in sufficient amount to bind the colored layer components into a uniform film, and at least one colorant in sufficient amount to uniformly color said colored layer; and

iv. a thermally activated adhesive layer directly on said colored layer.

2. The element of claim 1 where said support comprises polyethylene terephthalate.

3. The element of claim 1 or 2 wherein said support has a matte surface.

4. The element of any of claims 1-3 wherein said release surface on said support comprises polyvinyl alcohol.

5. The element of any of claims 1-4 wherein said photosensitive layer comprises the polycondensation product of 3-methoxy-4-diazo-diphenyl amine sulfate and 4,4′-bis-methoxy methyl-diphenyl ether precipitated as mesitylene sulfonate.

6. The element of any of claims 1-4 wherein said 25 photosensitive layer comprises the ester of bis-(3-benzoyl-4,5,6 trihydroxy phenyl)-methane and 2-diazo-1-naphthol-5-sulfonic acid.

7. The element of any of claims 1-6 wherein said photosensitive layer comprises one or more binders selected from the group consisting of polyvinyl butyral styrene/maleic anhydride copolymer; and a binder resin having the general formula:

-A-B-C-

wherein a plurality of each of components A, B and C occur in ordered or random sequence in the resin and wherein A is present in said resin at 5% to 30% by weight and comprises groups of the fomula:

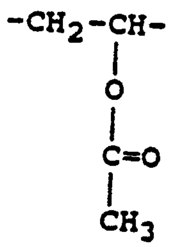

B is present in said resin at 4% to 30% by weight and comprises groups of the formula:

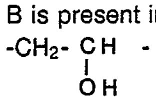

and C is present in said resin at 50% to 91% by weight; the weight amount of components A, B, and C being based on the total weight of the resin, and comprises acetal groups consisting of groups of the formulae:

I) 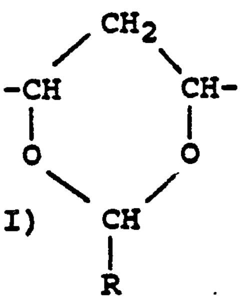 , II) 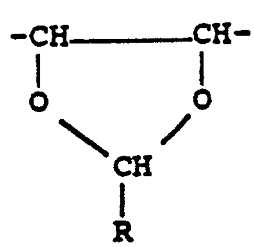 and III) 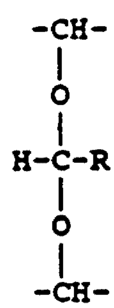

where R is lower alkyl (e.g. $C_{1-6}$ especially $C_{1-4}$) or hydrogen, and wherein said group I is present in component C at 75% to 85%, group II is present in component C at 3% to 5%, and group III is present in

component C at 10% to 22%, the percent basis for the acetal groups I, II, and III being on a mol basis of acetal groups I, II and III of component C.

8. The element of any of claims 1-7 wherein said photosensitive layer further comprises one or more ingredients selected from the group consisting of plasticizers, acid stabilizers, antistatic compositions, uv absorbers and surfactants.

9. The element of any of claims 1-8 wherein the coating weight of the photosensitive layer ranges from 0.1 to 5.0g/$m^2$.

10. The element of any of claims 1-9 wherein the colored layer comprises a binding resin selected from the group consisting of polyvinyl butyral styrene/maleic anhydride copolymer; and a binder resin having the general formula:

-A-B-C-

wherein a plurality of each of components A, B and C occur in ordered or random sequence in the resin and wherein A is present in said resin at 5% to 30% by weight and comprises groups of the formula:

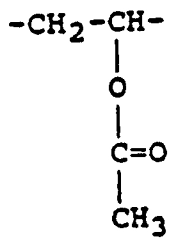

B is present in said resin at 4% to 30% by weight and comprises groups of the formula:

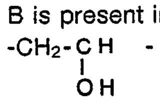

and C is present in said resin at 50% to 91% by weight; the weight amount of components A, B, and C being based on the total weight of the resin, and comprises acetal groups consisting of groups of the formulae:

I) 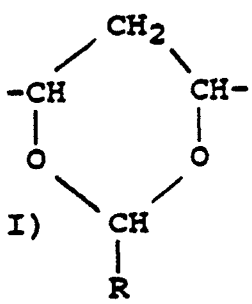 , II) 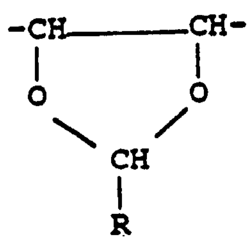 and III) 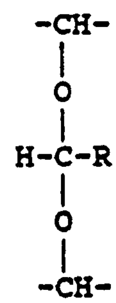

where R is lower alkyl (e.g. $C_{1-6}$ especially $C_{1-4}$) or hydrogen, and wherein said group I is present in component C at 75% to 85%, group II is present in component C at 3% to 5%, and group III is present in component C at 10% to 22%, the percent basis for the acetal groups I, II, and III being on a mol basis of acetal groups I, II, and III of component C.

11. The element of any of claims 1-10 wherein said adhesive layer comprises one or more aqueous alkaline insoluble polymers having a softening temperature in the range of from 60°C to 180°C.

12. The element of any of claims 1-11 wherein said adhesive layer comprises a polyvinyl acetate homopolymer or vinyl acetate containing copolymer.

13. The element of any of claims 1-12 wherein said adhesive layer further comprises a plasticizer.

14. A method for forming a colored image which comprises:

A. providing a multilayered imaging element which comprises:

i. a transparent support having a release surface, and

ii. a photosensitive layer directly on said release surface, which photosensitive layer is substantially free of dyes and pigments and comprises in admixture a light sensitive component selected from the group consisting of polymeric diazonium compounds and quinone diazides, and at least one aqueous alkaline

soluble or swellable binding resin, wherein said binding resin is present in sufficient amount to bind the photosensitive layer components into a uniform film, and wherein said light sensitive component is present in sufficient amount to cause an imagewise differentiation in said photosensitive layer upon imagewise exposure to sufficient imaging energy; and

iii. a colored layer directly on said photosensitive layer, which colored layer is substantially free of diazonium compounds and quinone diazides, which colored layer comprises an aqueous alkaline soluble or swellable binder resin in sufficient amount to bind the colored layer components into a uniform film, and at least one colorant in sufficient amount to uniformly color said colored layer; and

B. either

i. laminating said element with heat and pressure via said adhesive layer to a developer resistant receiver sheet; and removing said support by the application of peeling forces; and imagewise exposing said photosensitive layer to actinic radiation; or

ii. laminating said element with heat and pressure via said adhesive layer to a developer resistant receiver sheet; and imagewise exposing said photosensitive layer to actinic radiation; and removing said support by the application of peeling forces; and

C. removing the non-image areas of said photosensitive layer with a liquid developer, which removing is conducted at a temperature at which said adhesive layer is substantially non-tacky.

15. The method of claim 14 wherein steps A through C are repeated at least once whereby another photosensitive element having at least one different colorant is laminated onto said receiver sheet over the non-removed portions of the previously laminated photosensitive layer or layers.

16. The method of claim 14 or 15 wherein there is used the feature defined in any of claims 2-13.

17. The method of any of claims 14-16 wherein said adhesive layer comprises one or more aqueous alkaline insoluble polymers having a softening temperature in the range of from 150°F to 180°F (65°C to 82°C).

18. A multilayered imaging element which comprises

i. a transparent support having a release surface; and

ii. a photosensitive layer directly on said release surface, which photosensitive layer is substantially free of binding resins, dyes and pigments and comprises a light sensitive component selected from the group consisting of film forming polymeric diazonium compounds and quinone diazides, wherein said light sensitive component is present in sufficient amount to form a uniform film and to cause an imagewise differentiation in said photosensitive layer upon imagewise exposure to sufficient imaging energy; and

iii. a colored layer directly on said photosensitive layer, which colored layer is substantially free of diazonium compounds and quinone diazides, which colored layer comprises an aqueous alkaline soluble or swellable binder resin in sufficient amount to bind the colored layer components into a uniform film, and at least one colorant in sufficient amount to uniformly color said colored layer; and

iv. a thermally activated adhesive layer directly on said colored layer.

19. The element of claim 18 having the feature defined in any of claims 2-13.

20. A method for forming a colored image which comprises:

A. providing a multilayered imaging element which comprises

i. a transparent support having a release surface; and

ii. a photosensitive layer directly on said release surface, which photosensitive layer is substantially free of binding resins, dyes and pigments and comprises a light sensitive component selected from the group consisting of polymeric diazonium compounds and quinone diazides wherein said light sensitive component is present in sufficient amount to form a uniform film and to cause an imagewise differentiation in said photosensitive layer upon imagewise exposure to sufficient imaging energy; and

iii. a colored layer directly on said photosensitive layer, which colored layer is substantially free of diazonium compounds and quinone diazides, which colored layer comprises an aqueous alkaline soluble or swellable binder resin in sufficient amount to bind the colored layer components into a uniform film, and at least one colorant in sufficient amount to uniformly color said colored layer; and

iv. a thermally activated adhesive layer directly on said colored layer; and

B. either

i. laminating said element with heat and pressure via said adhesive layer to a developer resistant receiver sheet; and removing said support by the application of peeling forces; and imagewise exposing said photosensitive layer to actinic radiation; or

ii. laminating said element with heat and pressure via said adhesive layer to a developer resistant receiver sheet; and imagewise exposing said photosensitive layer to actinic radiation; and removing said support by the application of peeling forces; and

C. removing the non-image areas of said photosensitive layer with a liquid developer, which removing

is conducted at a temperature at which said adhesive layer is substantially non-tacky.

21. The method of claim 20 wherein steps A through C are repeated at least once whereby another photosensitive element having at least one different colorant is laminated onto said receiver sheet over the non-removed portions of the previously laminated photosensitive layer or layers.

22. The method of claim 20 or 21 wherein there is used the feature defined in any of claims 2-13.

23. The method of any of claims 20-22 wherein said adhesive layer comprises one or more aqueous alkaline insoluble polymers having a softening temperature in the range from 150° F to 180° F (65° C to 82° C).